Europäisches Patentamt

European Patent Office

Office européen des brevets

(11) Publication number: **0 246 788**

**A2**

(12) # EUROPEAN PATENT APPLICATION

(21) Application number: 87304135.4

(51) Int. Cl.⁴: **H03K 3/543** , H03K 3/57 , H03K 3/013

(22) Date of filing: **08.05.87**

(30) Priority: **13.05.86 GB 8611660**

(43) Date of publication of application:
**25.11.87 Bulletin 87/48**

(84) Designated Contracting States:
**DE FR GB**

(71) Applicant: **BRITISH AEROSPACE PUBLIC LIMITED COMPANY**
**11 Strand**
**London WC2N 5JT(GB)**

(72) Inventor: **Hudson, James**
**British Aerospace PLC Army Weapons Six Hills Way**
**Stevenage Herfordshire SG1 2DA(GB)**

(74) Representative: **Dowler, Edward Charles et al**
**British Aerospace Public Limited Company Corporate Patents Department Brooklands Road**
**Weybridge Surrey, KT13 OSJ(GB)**

(54) **Pulse generating circuits.**

(57) Known pulse generating circuits may suffer from the effects of nuclear radiation which may cause the circuit to suffer permanent damage and may initiate premature firing of components within the circuit. The circuit disclosed incorporates a spark discharge trigger tube and a power MOSFET transistor which makes the circuit "harder" to the effects of nuclear radiation.

*Fig.1.*

## PULSE GENERATING CIRCUITS

This invention relates to pulse generating circuits.

According to one aspect of the invention there is provided a pulse generating circuit comprising:-

first and second storage capacitors;

supply means for supplying current to each storage capacitor to charge it;

an electrically triggerable spark discharge switch for discharging the first storage capacitor into a load; and

a high power field-effect transistor connected for being switched to discharge said second storage capacitor into the trigger circuit of the spark discharge switch.

According to a second aspect of the invention, there is provided a pulse generating circuit comprising:-

a positive high voltage supply conductor;

a positive intermediate voltage conductor;

a ground rail conductor;

a high voltage storage capacitor having one side connected to said high voltage supply conductor, and its other side connected to a pulse output terminal, and via a resistor, to said ground rail conductor,

a spark discharge switch having its anode connected to said high voltage supply conductor, its other main electrode connected to said ground rail conductor, and a trigger signal terminal;

a high power field-effect transistor having its source connected to said ground rail conductor, its drain connected via a resistor to said intermediate voltage conductor, and its gate connected to an input terminal of the circuit for receiving a control signal which initiates the generation of a pulse at said output terminal; and

a second capacitor connected between said drain of the field-effect transistor and said trigger signal terminal of the spark discharge switch.

Advantageously, a voltage limiting diode is connected between the source and drain of the power field-effect transistor.

A leakage resistor may be connected between the ground rail conductor and the high voltage supply conductor.

The spark discharge switch may be of the kind comprising an evacuated envelope, an anode and another electrode spaced from one another within the envelope, and a film resistor within the envelope connected between said other electrode and a trigger input terminal of the switch.

For a better understanding of the invention, reference will now be made, by way of example, to the accompanying drawings in which:-

Figure 1 is a schematic circuit diagram of a pulse generating circuit; and

Figures 2 to 5 are stages in the generation of a pulse using the Figure 1 circuit.

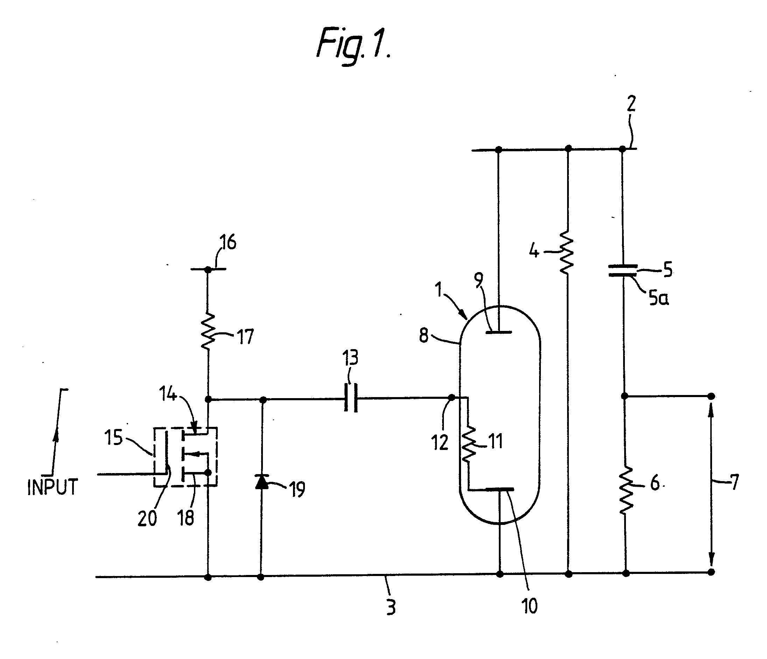

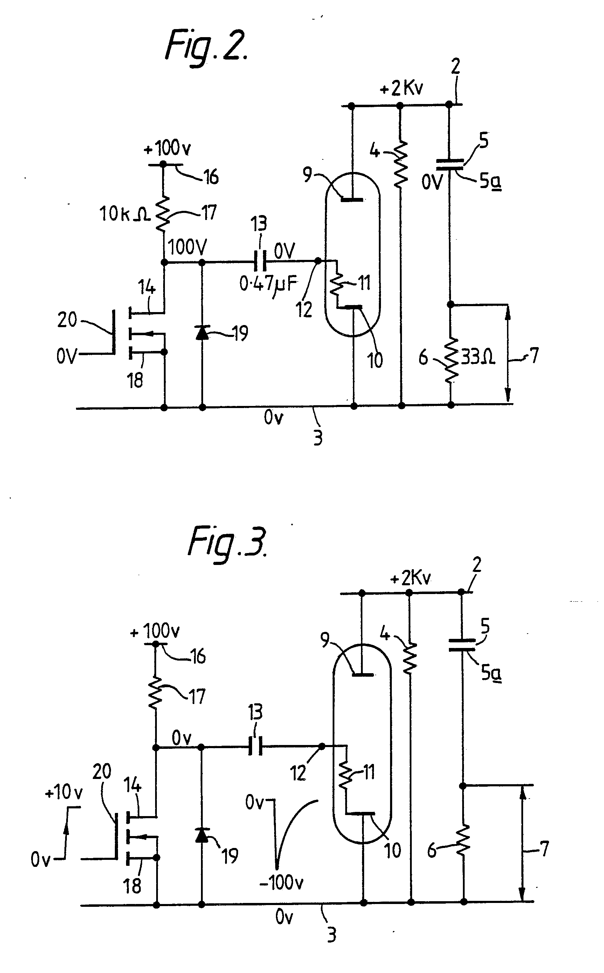

The pulse generating circuit shown in Figure 1 comprises a trigger tube 1 connected between a high voltage conductor rail 2 and a common conductor rail 3 which is maintained at 0V. A leak resistor 4 is connected in parallel with a storage capacitor 5 and a series resistor 6, which, in turn, are connected in parallel with the tube 1. The output from the circuit is taken at 7 i.e. across the series resistor 6. The tube 1 comprises an evacuated envelope 8 within which there is spaced apart two electrodes, an anode 9 and an adjacent 10, each electrode being connected to its appropriate conductor rail i.e. anode 9 to rail 2 and adjacent 10 to rail 3. Also connected to the adjacent 10 is a trigger circuit 11 which comprises a thick film resistor, the other end of the trigger circuit 11 providing a trigger input terminal 12 to the tube 1. The input to terminal 12 is obtained from the discharge of a second storage capacitor 13 which is connected between the terminal 12 and a drain terminal 14 of a N-channel power MOSFET electronic switch 15, the drain terminal 14 also being connected to a trigger voltage input conductor rail 16 via a resistor 17. The source terminal 18 of the switch 15 is connected to the common conductor rail 3. A diode 19 is connected to the rail 3 and the drain terminal 14 i.e. across the switch 15. In order to generate an output pulse, an input signal is applied to the gate terminal 20 which operates the circuit, and this operation will now be described in more detail with reference to Figures 2 to 5.

Assigning the following values to the circuit components: high voltage rail 2 : +2kV

common rail 3 : 0V

series resistor 6 : 33Ω

storage capacitor 13 : 0.47μF

trigger voltage input rail 16 : +100V

resistor 17 : 10kΩ

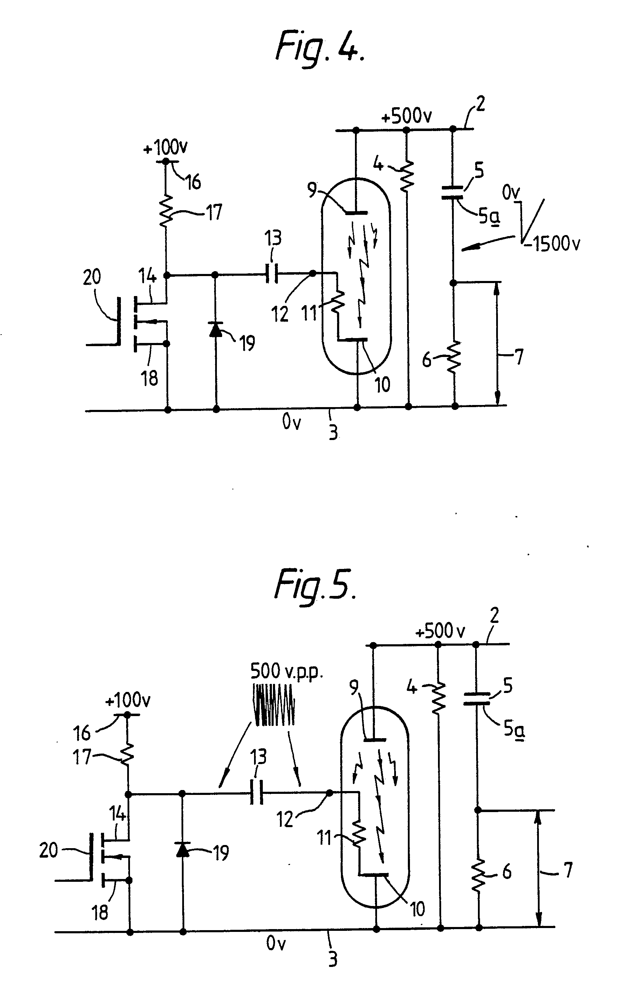

In Figure 2, there is initially a voltage of 100V across the drain 14 and source 18 of the MOSFET switch 15, 100V across the storage capacitor 13, 100V across the diode 19, +2kV across the storage capacitor 5, 0V across the trigger circuit 11, and 0V on the gate 20 of the switch 15. When an input pulse of 10V is applied to the gate 20, as shown in Figure 3, the potential of the drain 14 step changes to 0V causing the trigger circuit 11 to step change to -100V and the storage capacitor 13 to discharge its stored energy (due to its initial potential of 100V) into the trigger circuit 11 via input terminal 12. The trigger circuit 11 causes the tube 1 to fire due to some of the particles from the thick film resistor moving into the vacuum between the anode 9 and the adjacent 10. Firing of the tube I causes the storage capacitor 5 to discharge into the output i.e. across resistor 6, and an arc appears between the anode 9 and adjacent 10. 500V is required to maintain this arc, therefore the potential of the high voltage rail 2 is pulled down to +500V as illustrated in Figure 4 and the lower plate 5a of the capacitor 5 step changes to -l500V to discharge energy into the series resistor 6 and hence into the output 7. During this discharge of energy to provide the output signal, the trigger input terminal I2 of the tube I causes a 500V peak-to-peak radio frequency interference (RFI) to be fed back through the capacitor I3 to the switch I5 as shown in Figure 5, the RFI emanating from the discharge within the tube I. The diode I9 protects the switch I5 from any negative excursions of the unwanted emissions from the trigger input terminal I2.

Circuits of this simplicity have been restricted in the past due to the lack of high voltage transistors capable of withstanding the 500V RFI emitted from the terminal I2 when the tube I is fired.

Although negative trigger voltages i.e. -l00V applied to the terminal I2, are not recommended by manufacturers of trigger tubes, there is no evidence that using negative voltages reduces the life of the tubes, and hence a N-channel power MOSFET can be used to switch the tube as described previously. The resulting circuit has very few components and exploits the use of N-channel transistors which are cheaper and are of higher performance than P-channel devices.

An advantage of the circuit described is that the input voltage, the trigger tube I and the output 7 are all referenced to 0V. This enables simple synchronisation of multiple channel operation to be achieved.

The resistance of the trigger tube should be chosen to be at least I0 to minimise the physical size of the power MOSFET required.

The use of a power MOSFET device makes the circuit harder to nuclear radiation than equivalent bipolar circuits, as the MOSFET can be stored in a nuclear environment without suffering permanent damage. The hard vacuum of the trigger tube I also makes the circuit harder as any incident radiation will not contaminate the vacuum, and initiate premature firing of the tube I.

## Claims

1. A pulse generating circuit comprising:-
first and second storage capacitors;
supply means for supplying current to each storage capacitor to charge it;

an electrically triggerable spark discharge switch for discharging the first storage capacitor into a load; and
a high power field-effect transistor connected for being switched to discharge said second storage capacitor into the trigger circuit of the spark discharge switch.

2. A pulse generating circuit comprising:-
a positive high voltage supply conductor;
a positive intermediate voltage conductor;
a ground rail conductor;
a high voltage storage capacitor having one side connected to said high voltage supply conductor, and its other side connected to a pulse output terminal, and via a resistor, to said ground rail conductor,
a spark discharge switch having its anode connected to said high voltage supply conductor, its other main electrode connected to said ground rail conductor, and a trigger signal terminal;
a high power field-effect transistor having its source connected to said ground rail conductor, its drain connected via a resistor to said intermediate voltage conductor, and its gate connected to an input terminal of the circuit for receiving a control signal which initiates the generation of a pulse at said output terminal; and
a second capacitor connected between said drain of the field-effect transistor and said trigger signal terminal of the spark discharge switch.

3. A pulse generating circuit according to Claim 2, wherein a voltage limiting diode is connected between the source and drain of the power field-effect transistor.

4. A pulse generating circuit according to Claim 2 or 3, wherein a leakage resistor is connected between the ground rail conductor and the high voltage supply conductor.

5. A pulse generating circuit according to any one of Claims 2 to 4, wherein the spark discharge switch comprises an evacuated envelope, an anode and another electrode spaced from one another within the envelope, and a film resistor within the envelope connected between said other electrode and a trigger input terminal of the switch.

6. A pulse generating circuit according to any one of Claims 2 to 5, wherein the high power field-effect transistor is an N-channel device.

# Fig.1.

Fig.2.

Fig.3.

# Fig. 4.

+500v 2

+100v
16
17
4
9
5
14
20
13
5a
0v
12 11
-1500v
18 19
10
6 7
0v
3

# Fig. 5.

+500 v 2

500 v.p.p.
+100v
16
4
17
9
5
14
13
5a
20
12
19
11
18
10
6 7
0v
3